# NEUE EUROPÄISCHE PATENTSCHRIFT

(11) **EP 2 314 732 B2**
(45) Veröffentlichungstag und Bekanntmachung des Hinweises auf die Entscheidung über den Einspruch: **03.08.2016**
(45) Hinweis auf die Patenterteilung: 27.03.2013
(21) Anmeldenummer: 10188347.8
(22) Anmeldetag: 21.10.2010
(51) Int. Cl.: C23C 14/02, C23C 14/08, C03C 17/34, H01L 31/18

(54) **Verfahren zur Beschichtung eines Substrats mit einer TCO-Schicht und Dünnschichtsolarzelle**
Method for coating a substrate with a TCO coating and thin film solar cell
Procédé de revêtement d'un substrat doté d'une couche de TCO et cellule solaire en couche fine

(30) Priorität: 21.10.2009 DE 102009050234
(43) Veröffentlichungstag der Anmeldung: 27.04.2011
(73) Patentinhaber: VON ARDENNE GmbH, 01324 Dresden (DE)
(72) Erfinder: Dimer, Martin, 01309 Dresden (DE); Schössler, Tina, 01277 Dresden (DE); Knoth, Thomas, 01277 Dresden (DE); Sturm, Ralf, 01127 Dresden (DE); Graupner, Uwe, 01187 Dresden (DE); Thumsch, Martin, 01324 Dresden (DE); Hecht, Hans-Christian, 01689 Weinböhla (DE)
(74) Vertreter: Lippert, Stachow & Partner

(56) Entgegenhaltungen:
- EP-A1- 1 503 227
- EP-A1- 1 624 494
- WO-A1-03/054939
- WO-A1-2005/072946
- WO-A2-2009/117083
- WO-A2-2009/117083
- DE-A1-102009 050 234
- FR-A1- 2 942 480
- JP-A- 2007 231 361
- JP-A- 2007 231 361
- US-A- 5 605 609
- US-A1- 2006 169 317
- US-A1- 2007 025 252
- US-A1- 2007 228 369
- US-A1- 2009 084 438
- US-A1- 2009 120 496
- HONG J-S ET AL: "Enhanced properties of In2O3-ZnO thin films deposited on soda lime glass due to barrier layers of SiO2 and TiO2", THIN SOLID FILMS, ELSEVIER-SEQUOIA S.A. LAUSANNE, CH, vol. 467, no. 1-2, 22 November 2004 (2004-11-22), pages 158-161, XP004557044, ISSN: 0040-6090, DOI: 10.1016/J.TSF.2004.03.014
- ZHINONG ET AL: 'Properties of indium tin oxide films deposited on unheated polymer substrates by ion beam assisted deposition' THIN SOLID FILMS Bd. 517, 31 Juli 2009, Seiten 5395 - 5398
- SONG S. ET AL: 'Structural, electrical and optical properties of ITO films with a thin TiO2 seed layer prepared by RF magnetron sputtering' VACUUM Bd. 83, 01 Mai 2009, Seiten 1091 - 1094
- HUANTAO D. ET AL: 'Effect of nucleation layer morphology on crystal quality, surface morphology and electrical properties of AlGaN/GaN heterostructures' JOURNAL OF SEMICONDUCTORS Bd. 30, Oktober 2009, Seiten 5002-1 - 5002-3
- WEI S. ET AL: 'Effects of seed layer on the structure and property of zinc oxide thin films electrochemically deposited on ITO-coated glass' APPLIED SURFACE SCIENCE Bd. 254, 2008, Seiten 6605 - 6610
- BARRANCO A. ET AL: 'Chemical stability of Sin+ species in SiOx (x>2) thin films' JOURNAL OF VACUUM SCIENCE & TECHNOLOGY A Bd. 19, 2001, Seiten 136 - 144

## Beschreibung

Die Erfindung betrifft allgemein ein Verfahren zur Beschichtung eines Substrats mit einer transparenten leitfähigen Oxidschicht, nachfolgend als TCO-Schicht bezeichnet, sowie eine Dünnschichtsolarzelle.

Die Beschichtung erfolgt auf einem Substrat mittels Physikalischer Gasphasenabscheidung (PVD-Verfahren), regelmäßig durch Sputtern, in einem Durchlaufprozess, in welchem das Substrat durch eine Beschichtungskammer hindurch bewegt und dabei beschichtet wird. Zum Sputtern wird das Substrat an einer Kathodenanordnung als Beschichtungsquelle vorbeibewegt, die ein Target des abzuscheidenden Materials aufweist. In die Beschichtungskammer wird ein Arbeitsgas eingeleitet, dem ein, verglichen zum Arbeitsgas, geringerer Anteil Wasserstoff oder anderen Gasen zugesetzt werden kann.

Derartige, leitfähige und transparente TCO-Schichten werden aufgrund ihrer optischen Eigenschaften und insbesondere im UV- und im IR-Bereich für eine Reihe verschiedener Anwendungsgebiete verwendet, z.B. als transparente Elektrode in Dünnfilm-Solarzellen oder in Flachbildschirmen, als Blockerschicht in einem selektiven Schichtsystem für Glas oder als IR-Reflexionsschicht. Entsprechend dieser unterschiedlichen Anwendungsmöglichkeiten kommen auch verschiedene Substrate in Betracht, z.B. Glas, Silizium oder metallische Substrate.

Es ist bekannt, transparente leitfähige Oxidschichten aus verschiedenen Metalloxidschichten (Transparent Conducting (Metal) Oxid - TCO) herzustellen, die aufgrund ihrer Dotierung mit einem Material der dritten Hauptgruppe des Periodensystems der Elemente, z.B. Aluminium, Indium, Gallium oder Bor die erforderliche Leitfähigkeit aufweisen. Auch mit Dotierungen durch Fluor, Yttrium oder Magnesium sind die gewünschten elektrischen Eigenschaften zu erzielen. Bekannt sind z.B. dotierte Schichten aus Indiumoxid, Zinnoxid oder Indium-Zinn-Oxid (ITO) wobei Schichten aus Zinkoxid an Bedeutung gewinnen, da sie deutlich preiswerter herzustellen, nicht toxisch, leicht zu dotieren und haltbar unter wasserstoffhaltiger Atmosphäre sind. ITO ist zudem gegenüber verschiedenen Säuren anfällig. Um die chemische und auch thermische Beständigkeit zu erhöhen, wurde in der US 2007/0228369 A1 zwischen dem ITO-Layer und dem Substrat ein mit Yttrium-Oxid dotierter Zirkonium-Oxid-Layer und optional ein Barriere-Layer aus SiO₂ eingefügt. Anschließend wurde die Oberfläche des ITO-Layers durch Ätzen strukturiert.

Aus der US 2007/275252 A1 ist es zudem bekannt, unter einer TCO-Schicht eine Schichtenfolge aus zwei dielektrischen Schichten, beispielsweise eine Schicht aus Siliziumdioxid auf einer Schicht aus einem hochbrechenden Metalloxid oder Siliziumoxinitrid, mit deutlich voneinander abweichendem Brechungsindex anzuordnen. Damit ist es möglich, die Reflexionsfarbe der TCO-Schicht zu beeinflussen.

Die Beschichtung erfolgt in Vakuumbeschichtungsanlagen, die je nach dem aufzubringenden Schichten oder Schichtsystemen eine oder mehrere Beschichtungskammern aufweisen. Als Target dient ein keramisches Metalloxid-Target, welches zur Einstellung des sowohl für die optischen als auch für die elektrischen Eigenschaften erforderlichen niedrigen spezifischer Flächenwiderstandes der Schicht wie beschrieben dotiert ist. Z.B. erfolgt die Dotierung durch die Anreicherung des Targetmaterials mit Aluminiumoxid in einstelligen Gewichtsprozenten. Ein solches Schichtmaterial ist als ZnO:Al oder AZO bekannt. Auch reaktive oder teilreaktive Sputtertechniken kommen zur Anwendung.

Auf die Transparenz und den spezifischen Flächenwiderstand der abgeschiedenen Schicht haben neben dem Targetmaterial auch die Sputteratmosphäre und andere Prozessparameter, wie Druck, auch Partialdrücke verschiedener Komponenten des Arbeitsgases, und Temperatur, insbesondere die Substrattemperatur oder die Energieeinspeisung einen Einfluss.

So wird beschrieben, dass durch die Einleitung von Wasserstoff in die Argonatmosphäre der Beschichtungskammer zur Erzeugung eines Argon-Wasserstoff-Plasmas die Leitfähigkeit der Schicht und die Reflexion im IR-Bereich erhöht wurden, bei unverändert guter Transmission im sichtbaren Bereich. Jedoch wird mit der Zugabe von Wasserstoff regelmäßig ein Abfall der Abscheiderate beobachtet, was sich nachteilig für eine effektive großtechnische Beschichtung in Durchlaufanlagen erweist. Darüber hinaus bereitet auch die großtechnische Umsetzung des Hochfrequenz-Magnetron-Sputterns (RF-Sputtern) von dotiertem ZnO Probleme hinsichtlich der Stabilität des Prozesses und damit der Schichthomogenität und hinsichtlich der Abscheiderate. Auch die Beschichtung mittels gepulstem Gleichspannungssputtern, d.h. unter pulsförmiger Einspeisung der elektrischen Energie in die Kathodenanordnung mit Frequenzen im Bereich von 3-50 MHz wird angewendet.

Die Substrattemperatur wird durch flächiges Heizen des Substrats vor dem Beschichtungsprozess unter Berücksichtigung des Energieeintrags während der Beschichtung eingestellt. Das Substrat wird meist auf 100°C und mehr erwärmt, wobei erst bei deutlich höheren Temperaturen von ca. 200-300°C akzeptable Flächenwiderstandswerte der abgeschiedenen Schicht erzielt werden.

Vor allem durch diesen Temperatureintrag während des Beschichtungsprozesses wird allerdings auch eine Ausdiffusion von Material aus dem Substrat in die abzuscheidende bzw. abgeschiedene Schicht begünstigt. Zur Verhinderung einer Verunreinigung der aktiven Schichten durch aus dem Substrat ausdiffundiertes Material ist deshalb die Abscheidung einer Barriereschicht ein übliches Verfahren. Die US2009/0126791 A1 und die US2007/0082140 A1 nutzen beispielsweise entsprechende Schichten.

Für die Verwendung in Dünnschichtsolarzellen, bei denen die TCO-Schicht als transparenter, elektrischer Flächenkontakt eingesetzt wird, den das einfallende Licht passiert, sind neben der hohen Transparenz und der guten elektrischen Leitfähigkeit der Kontaktschicht auch gute streuende Eigenschaften erforderlich. Denn ist dieser Flächenkontakt auf der Lichteinfallseite des Schichtstapels einer Solarzelle angeordnet, ist einerseits ein hoher Lichteinfall zu ermöglichen, andererseits ist ein gewisses Maß an Lichtstreuung in der Schicht günstig, um die Lichteinkopplung in den absorbierenden Halbleiter zu verbessern. Durch Mehrfachstreuung soll erzielt werden, dass das einfallende Licht im Schichtsystem einen möglichst langen Weg zurücklegt, um den Absorptionsanteil in der fotoaktiven Schicht zu erhöhen. Insbesondere sind Totalreflektionen des einfallenden Lichts zu unterbinden. Zur besseren Einkopplung des Lichts in das Schichtsystem wird unter anderem die TCO-Schicht an ihrer Grenze zur fotoaktiven Schicht mit einer rauen Oberfläche ausgestattet.

Eine bessere Einkopplung des Lichts erfolgt in der EP 1 624 494 A1 durch ein laminiertes Substrat, auf welchem mittels CVD- (Chemical Vapor Deposition) Verfahren eine Schichtenfolge aus Titanoxid, Siliziumoxid und Zinnoxid abgeschieden wird.

Um das zu erreichen, wird regelmäßig eine Abfolge verschiedener Schichten abgeschieden. Insbesondere ist es bekannt, zur Herstellung einer rauen, mittels PVD hergestellten TCO-Schicht, die nach der Abscheidung zunächst glatte Schicht mittels eines Ätzprozesses nachträglich aufzurauen ohne jedoch die Transmissionseigenschaften oder die elektrische Leitfähigkeit signifikant zu ändern.

Aufgabe der Erfindung ist es deshalb, ein einfaches Verfahren zur Beschichtung eines Substrats mit einer transparenten leitfähigen Oxidschicht aufzuzeigen, bei dem die Verunreinigung von Schichten des Schichtsystems durch Diffusion von Material aus dem Substrat minimiert und seine Schichteigenschaften bezüglich Lichteinkopplung und Transmission optimiert werden. Dazu werden unmittelbar aufeinanderfolgend auf dem Substrat eine Barriereschicht, eine Keimschicht und eine transparente leitfähige Oxidschicht (TCO-Schicht) abgeschieden. Es wird auch eine Dünnschichtsolarzelle beschrieben, die eine solche transparente leitfähige Oxidschicht umfasst..

Diese Aufgabe wird erfindungsgemäß durch ein Verfahren zur Beschichtung eines Substrats mit einer transparenten leitfähigen Oxidschicht mit den Merkmalen des Anspruchs 1 und eine Dünnschichtsolarzelle mit einem transparenten Substrat und einem darauf angeordneten Schichtsystem mit den Merkmalen des Anspruchs 5 gelöst. Die Ansprüche 2 bis 4 und 7 bis 9 geben Ausführungsvarianten dieser erfindungsgemäßen Lösung wieder.

Gemäß dem erfindungsgemäßen Verfahren zur Beschichtung eines Substrats mit einer transparenten leitfähigen Oxidschicht, die hier auch als TCO-Schicht bezeichnet wird, werden unmittelbar nacheinander die Schichten Barriereschicht, Keimschicht und TCO-Schicht, deren Funktionen folgend erläutert werden, mittels physikalischer Gasphasenabscheidung auf einem Substrat abgeschieden. Zunächst wird eine Barriereschicht auf das Substrat aufgebracht. Diese Barriereschicht dient der Behinderung der Diffusion von Material aus dem Substrat in Richtung der darüber abgeschiedenen Schichten des jeweiligen Schichtsystems und damit der Verhinderung der ungewollten Verunreinigung der TCO-Schicht und der sich daran anschließenden Schichten. Die Barriereschicht schützt insbesondere auch die fotoaktiven, halbleitenden Schichten vor einer Fehldotierung und damit verbundenen Störung der elektrischen und optischen Eigenschaften in diesen Schichten.

Im Anschluss an die Barriereschicht wird eine Keimschicht abgeschieden, deren Aufgabe es ist, ein definiertes Schichtwachstum der nachfolgenden TCO-Schicht einzustellen und damit die morphologischen, elektrischen und optischen Eigenschaften dieser TCO-Schicht entscheidend zu beeinflussen.

Für die Keimschicht wird ein siliziumhaltiges oxinitridisches oder nitridisches Material verwendet, so dass diese dann aus einer SiOₓN_{y}- oder SiₓN_{y}-Schicht mit 0<d≤3 und 0<y≤4 besteht.

Da diese Schicht jedoch ergänzend zur eigentlichen Barriereschicht abgeschieden wird und primär der Einstellung der Schichteigenschaften der TCO-Schicht dient, ist die Barrierewirkung der Keimschicht nachrangig. In der Regel wird sich also die Stärke der Barrierewirkung der Keimschicht verglichen zu jener der Barriereschicht unterscheiden. Die Barrierewirkung der Keimschicht darf also vermindert sein gegenüber der Barrierewirkung der Barriereschicht. Trotzdem kann diese Keimschicht jedoch zusätzliche Barrierewirkung entfalten und damit die Barriereschicht unterstützen.

In einer besonderen Ausgestaltung des Beschichtungsverfahrens können folglich beide zwischen Substrat und TCO-Schicht angeordnete Schichten aus den genannten siliziumhaltigen oxidischen und/oder nitridischen Materialien bestehen, wobei die Keimschicht im Vergleich zur Barriereschicht durch eine Verarmung oder aber Anreicherung des Sauerstoffanteils von SiOₓN_{y} oder SiOₓ und ergänzend oder alternativ durch eine Anreicherung oder aber eine Verarmung des Stickstoffanteils von SiOₓN_{y} oder SiₓN_{y} unter Berücksichtigung der Festlegung der Anteile auf die Bereiche 0<d≤3 und 0<y≤4 erzielt werden. Im Spezialfall können beide Schichten auch aus demselben Material bestehen und sich nur durch die entsprechenden Abscheidebedingungen unterscheiden.

Auf diese Keimschicht wird schließlich unmittelbar folgend die TCO-Schicht abgeschieden, die auf diese Weise bezüglich Ihrer Schichteigenschaften direkt von der darunter liegenden Keimschicht profitiert.

Entsprechend einer besonderen Ausgestaltung des Verfahrens wird eine Barriereschicht verwendet, die aus einem Siliziumoxynitrid (SiOxNy), Siliziumoxid (SiOx) oder Siliziumnitrid SixNy) mit 0<d≤3 und 0<y≤4 besteht. Die Barriereschicht wirkt gegenüber dem Substrat, indem sie Diffusionsvorgänge aus dem Substrat in die Schichtenfolge und somit darin begründete Einflüsse auf die Schichteigenschaften verhindert. Mittels Wahl und Einstellung der Prozessparameter zur Herstellung dieser Schicht wird die Barrierewirkung gegenüber den vorliegenden Materialien und die damit zu erwartenden Beeinflussungen durch das Substrat eingestellt. Mit einer auf diese Weise einstellbaren hohen Barrierewirkung kann eine Diffusion von Material aus dem Substrat in Richtung der TCO-Schicht wirksam verhindert oder zumindest um Größenordnungen verringert werden. So kann z.B. durch einen hohen Stickstoffanteil die Barrierewirkung gegenüber Natriumionen aus einem Glassubstrat verstärkt werden.

Die Barrierewirkung der Barriereschicht kann dabei konkret durch die Prozessparameter Verhältnis der Reaktivgaskomponenten Sauerstoff und Stickstoff zueinander und/oder den Druck und/oder die Temperatur während der Barriereschichtabscheidung eingestellt werden, wobei diese Nennung jedoch nicht ausschließend wirkend soll. Zudem erhöht natürlich auch eine dickere, unter den gleichen Bedingungen abgeschiedene Barriereschicht die Barrierewirkung.

Die Art sowie die Abscheidebedingungen der Keimschicht wiederum können derart gewählt werden, dass das Schichtwachstum der im Anschluss an diese Keimschicht abgeschiedenen TCO-Schicht so beeinflusst wird, dass diese TCO-Schicht einen gewünschten, im günstigsten Fall einen maximalen Hazewert bei geringstmöglichen Flächenwiderstandswert erreicht.

Der Hazewert kennzeichnet dabei die Güte der Rauhigkeit und/oder der Lichtstreueigenschaften der TCO-Schicht. Ein hoher Hazewert bedeutet dabei eine hohe Lichtstreuung, die entsprechend experimentell bestimmbar ist. Die Einstellung eines möglichst hohen Hazewertes dient damit der Optimierung des Wirkungsgrades bei der Umsetzung von Lichteinstrahlung in elektrische Leistung.

Unter Abscheidebedingungen wiederum seien sowohl die Prozessparameter der Abscheidung als auch deren zeitlichen Verlauf betrachtet. Damit sei explizite zugelassen, dass entsprechend einer besonderen Ausgestaltung des Verfahrens einzelne Prozessparameter im Verlauf der Abscheidung der Keimschicht nicht konstant gehalten, sondern systematisch und reproduzierbar variiert werden. Als Kriterium der Überprüfung werden dabei stets der Hazewert der auf der jeweiligen Keimschicht abgeschiedenen TCO-Schicht sowie ihr Flächenwiderstand herangezogen.

Mit Hilfe multivariater Analysemethoden ist dabei die Ermittlung der optimalen Abscheidebedingungen bei gleichzeitiger Untersuchung mehrerer Prozessparameter möglich.

Da ein direkter Zusammenhang zwischen dem Hazewert einer TCO-Schicht definierter Dicke sowie der Morphologie dieser TCO-Schicht festgestellt wurde, kann auch die Morphologie der TCO-Schicht als eine der Haupteinflussgrößen auf den Hazewert zur Bestimmung möglichst optimaler Abscheidebedingungen der Keimschicht unter der TCO-Schicht herangezogen werden. Die durch das erfindungsgemäße Verfahren abgeschiedenen TCO-Schichten zeigen in der Regel ein Säulenwachstum, das sich über die gesamte Schichtdicke erstreckt, wobei die laterale Kristallitgröße der Kristallitsäulen in der TCO-Schicht je nach Abscheidebedingungen der Keimschicht stark variieren kann. Für hohe Hazewerte erweist es sich als günstig, die Art der Keimschicht sowie deren Abscheidebedingungen so zu wählen, dass eine maximale laterale Kristallitgröße der auf der Keimschicht abgeschiedenen TCO-Schicht erreicht wird.

In einer Ausgestaltung des erfindungsgemäßen Verfahrens werden dabei die beschriebenen Eigenschaften der nachfolgend abgeschiedenen TCO-Schicht dadurch optimiert, dass bei der Abscheidung der Keimschicht Wachstumsphasen, d.h. Phasen, in denen die Prozessparameter so gewählt sind, dass die Keimschichtdicke effektiv wächst, mit Ruhephasen, d.h. Phasen, in denen die Prozessparameter so gewählt sind, dass die Keimschichtdicke effektiv konstant bleibt, und/oder Rücksputterphasen, d.h. Phasen, in denen die Prozessparameter so gewählt sind, dass die Keimschichtdicke effektiv abnimmt, abwechseln. Dadurch wird eine spezielle Behandlung der Wachstumsfront dieser Schicht erreicht.

Aufgrund des Zusammenhangs zwischen Morphologie der TCO-Schicht und der Keimschicht, sind zudem die Prozessparameter für die TCO-Schichtabscheidung in einem weitaus größeren Bereich variierbar, so dass auch die gewünschten Transmissions- und elektrischen Eigenschaften durch Wahl einer hierfür günstigen Keimschicht zu beeinflussen sind: Das System aus Barriereschicht, Keimschicht und TCO-Schicht enthält zur Beeinflussung der TCO-Schichteigenschaften eine höhere Zahl an Freiheitsgraden als ein System, dass nur aus Barriereschicht und TCO-Schicht besteht. Dies gestattet insbesondere auch die Abscheidung von einem keramischen, dotierten Metalloxid-Target.

Entsprechend einer weiteren Ausgestaltung kann die Keimschicht aus dem gleichen oder ähnlichen Material hergestellt werden.

In einer konkreten Variante der Abscheidung der Keimschicht können dabei die Eigenschaften der nachfolgenden TCO-Schicht über die Wahl der folgenden Prozessparameter: Verhältnis der Reaktivgaskomponenten Sauerstoff und Stickstoff und/oder Verhältnis der Reaktivgaskomponenten zu Sputterkomponenten und/oder Druck und/oder Temperatur während der Abscheidung der Keimschicht eingestellt werden.

Beispielsweise kann zur Herstellung der Keimschicht der Sauerstoffanteil im Vergleich zur Barriereschicht verarmt und/oder der Stickstoffanteil erhöht sein.

Zur Erhöhung der lichtstreuenden Eigenschaften der TCO-Schicht und damit des Hazewertes bei gleichbleibender Transparenz und gleichem Flächenwiderstand wird in einer vorteilhaften Ausführung des Verfahrens die Oberfläche der TCO-Schicht nach deren Abscheidung durch einen zusätzlichen Ätzschritt aufgeraut und/oder strukturiert.

Ergänzend dazu können zur Einstellung der Oberflächenstruktur der TCO-Schicht die Ätzparameter, insbesondere das Ätzmittel, die Ätzdauer und die Ätztemperatur an die verwendete Keimschicht angepasst werden bzw. kann die Keimschicht umgekehrt so gewählt werden, dass ein zusätzlicher Ätzschritt nach der TCO-Abscheidung eine besonders vorteilhafte Wirkung auf den Hazewert der Schicht bei vergleichbarer Transparenz und vergleichbaren Flächenwiderstand hat.

Die erfindungsgemäße Dünnschichtsolarzelle, die unter Zuhilfenahme des hier beschriebenen Verfahrens hergestellt werden kann, besteht aus einem auf einem transparenten Substrat angeordneten Schichtsystem, welches folgende Schichten vom Substrat aufwärts unmittelbar aufeinanderfolgend enthält: Eine Barriereschicht zur Behinderung einer Materialeinwirkung auf eine der darüber liegenden Schichten der Dünnschichtsolarzelle, insbesondere deren fotoaktiver Schichten, die durch Diffusion von Material aus dem Substrat erfolgen kann; eine Keimschicht aus einem Material, welches geeignet ist, ein definiertes Schichtwachstum für eine auf der Keimschicht abzuscheidenden TCO-Schicht zu erzeugen, eine TCO-Schicht als eine erste Kontaktschicht; einen fotoaktiven Schichtstapel und einen Gegenkontakt als eine zweite Kontaktschicht. Sie bietet somit einen besonders einfachen Aufbau.

Dabei sei betont, dass die so aufgebaute Dünnschichtsolarzelle sowohl für einen Lichteinfall von der Substratseite her als auch für einen Lichteinfall von der Gegenkontaktseite her eingesetzt werden kann. Für einen Lichteinfall von der Substratseite ist jedoch eine notwendige Bedingung darin zu sehen, dass sowohl die Barriereschicht als auch die Keimschicht eine hinreichende Transparenz aufweisen, um den überwiegenden Anteil des von der Substratseite einfallenden Lichts in Richtung TCO-Schicht und fotoaktiven Schichtstapel weiterzuleiten.

In einer günstigen Ausgestaltung der erfindungsgemäßen Dünnschichtsolarzelle weist dabei die TCO-Schicht eine ausgeprägte säulenartige Kristallitstruktur auf. Dies ermöglicht eine besonders günstige Lichtstreuung, die sich in einem hohen Hazewert dieser TCO-Schicht ausdrückt, ohne dass damit der Flächenwiderstand der TCO Schicht signifikant verändert, insbesondere nicht signifikant erhöht wird.

In einer weiteren günstigen Ausgestaltung der erfindungsgemäßen Dünnschichtsolarzelle weist die TCO-Schicht eine strukturierte und/oder aufgerauhte Oberfläche auf, was wiederum zur Erhöhung des Hazewertes beiträgt, der wie oben schon erwähnt, experimentell bestimmbar ist.

Mit einfachen Mitteln herstellbar ist dabei eine Dünnschichtsolarzelle, bei der die Barriereschicht aus einem SiOₓN_{y} oder SiOₓ oder SiₓN_{y} mit 0<x≤3 und 0<y≤4 mit hoher Barrierewirkung gegen die Diffusion von Material aus dem Substrat besteht. Die Abscheidung von siliziumhaltigen oxidischen und/oder nitridischen Materialien mit verschiedenen, bekannten, einfachen und gut beherrschbaren PVD-Verfahren möglich. Die Herstellung der erfindungsgemäßen Dünnschichtsolarzelle kann noch weiter vereinfacht werden, wenn auch für die Keimschicht siliziumhaltige oxinitridische oder nitridische Materialien verwendet werden, so dass diese dann aus einer SiOₓN_{y}- oder SiₓN_{y}-Schicht mit 0<d≤3 und 0<y≤4 besteht. Dabei wird die Barriereschicht auf die gewünschte Barrierewirkung optimiert, während die Keimschicht auf die morphologischen, elektrischen und optischen Eigenschaften der auf dieser Keimschicht abzuscheidenden TCO-Schicht hin optimiert wird. Dazu werden die Abscheidebedingungen der Keimschicht in Vergleich zu denen der Barriereschicht durch die Wahl anderer Prozessparameter bzw. die Wahl eines entsprechenden Verlaufs dieser Prozessparameter verändert. Generell ist es auch möglich, dass die Keimschicht der erfindungsgemäßen Dünnschichtsolarzelle in einer besonderen Ausführungsform einen Gradienten und/oder eine sprunghafte Änderung ihrer Schichteigenschaften aufweist.

Natürlich ist es auch denkbar, dass nur die Keimschicht aus einem siliziumhaltigen oxinitridischen oder nitridischen Material besteht.

Die Erfindung soll anhand eines Ausführungsbeispieles zweier geätzten TCO-Schichten näher erläutert werden. Dazu zeigen
- Fig. 1a: die Oberfläche einer ersten TCO-Schicht in 20.000-facher Vergrößerung,
- Fig. 1b: einen Bruch durch den Schichtstapel mit der TCO-Schicht gemäß Fig. 1a in 50.000-facher Vergrößerung,
- Fig. 2a: die Oberfläche einer anderen TCO-Schicht in 20.000-facher Vergrößerung,
- Fig. 2b: einen Bruch durch den Schichtstapel mit der TCO-Schicht gemäß Fig. 2a in 50.000-facher Vergrößerung, und
- Fig. 3: die grundsätzliche Schichtenfolge einer Dünnschichtsolarzelle unter Verwendung einer TCO-Schicht als erste Kontaktschicht.

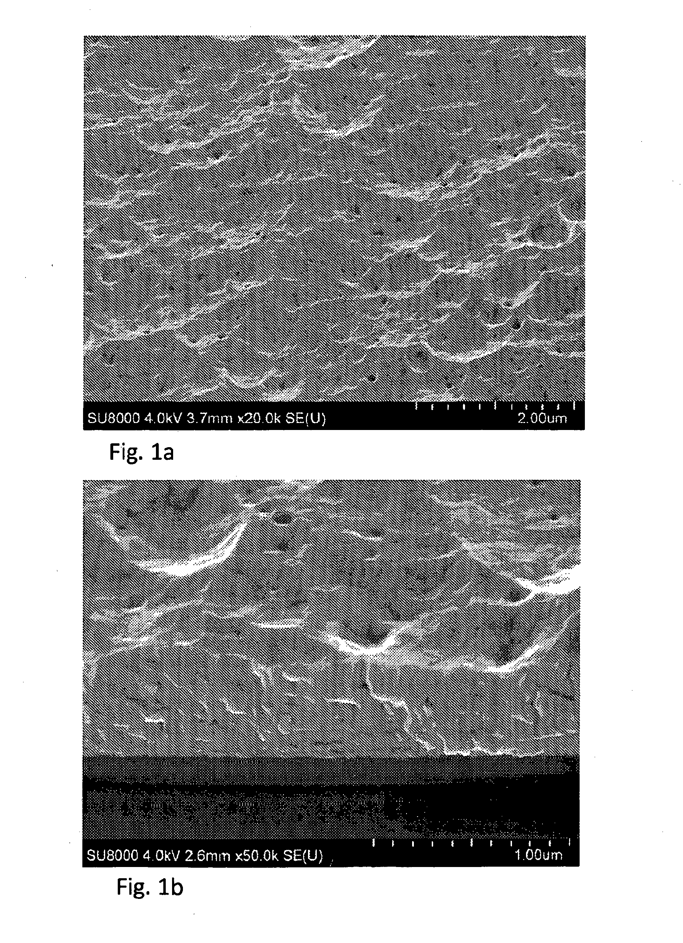

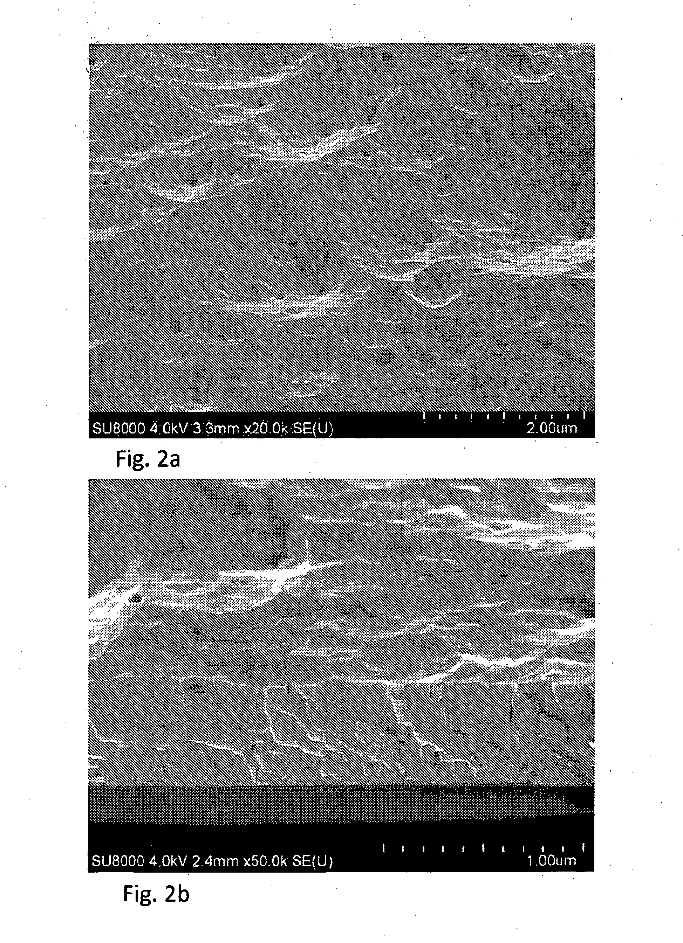

Beide TCO-Schichten 4 vergleichbarer Dicke wurden auf einem Floatglassubstrat 1 auf eine Siliziumoxynitrid-Barriereschicht 2 und eine Siliziumoxynitrid-Keimschicht 3 folgend abgeschieden. Fig. 1a zeigt die Oberfläche in 20000-facher Vergrößerung und Fig. 1b einen Bruch durch den Schichtstapel in 50000-facher Vergrößerung der ersten TCO-Schicht 4, die auf einer nichtoptimierten Keimschicht 3 abgeschieden wurde, Fig. 2a und Fig. 2b zeigen vergleichbare Bilder der zweiten TCO-Schicht 4 die auf einer optimierten Siliziumoxynitrid-Keimschicht 3 abgeschieden wurde.

Die unmittelbar auf dem Substrat 1 aus Floatglas abgeschiedene dielektrische Barriereschicht 2, besteht dabei in beiden Fällen aus unter gleichen Bedingungen abgeschiedenene unterstöchiometrischem Siliziumoxynitrid (SiₓN_{y}). Sie fungiert als Barriereschicht 2 für diffundierende Natriumionen des Glases in das Schichtsystem.

Mit der Abscheidung dieser Barriereschicht 2 kann zudem das vom Glassubstrat 1 mit in die Beschichtungsanlage eingeschleppte Wasser vom Substrat 1 entfernt werden, ohne dass dieser Vorgang Einfluss auf die nachfolgend aufgebrachte Schichtenfolge ausübt. Denn neben der Eignung als Barriereschicht 2 erweist sich das Material zudem wesentlich unempfindlicher gegenüber Wasser als die dann folgenden Schichten.

Über der Barriereschicht 2 wird eine Keimschicht 3 abgeschieden. Auch hierfür wurde in beiden Fällen ein Siliziumoxynitrid abgeschieden. Die Prozessparameter wurden hierbei in beiden Fällen während der gesamten Abscheidung nicht zeitlich variiert, jedoch wurde das Reaktivgasverhältnis von Sauerstoff zu Stickstoff für die Abscheidung der Keimschicht 3 des Schichtstapels der Figs. 2a und 2b im Vergleich zu der Keimschicht 3 des Schichtstapels der Figs. 1a und 1b signifikant verändert. Dies führt zu einer Vergrößerung der lateralen Kristallitgröße der darauf folgenden und unter wiederum gleichen Bedingungen wie die TCO-Schicht 4 der Figs. 1a und 1b abgeschiedenen TCO-Schicht 4 in den Figs. 2a und 2b um ca 50%, was eine entsprechende Erhöhung ihres Hazewertes insbesondere nach Ätzung der TCO-Schicht 4 nach ihrer Abscheidung mit für beide Schichten gleichem Ätzprozess nach sich zieht.

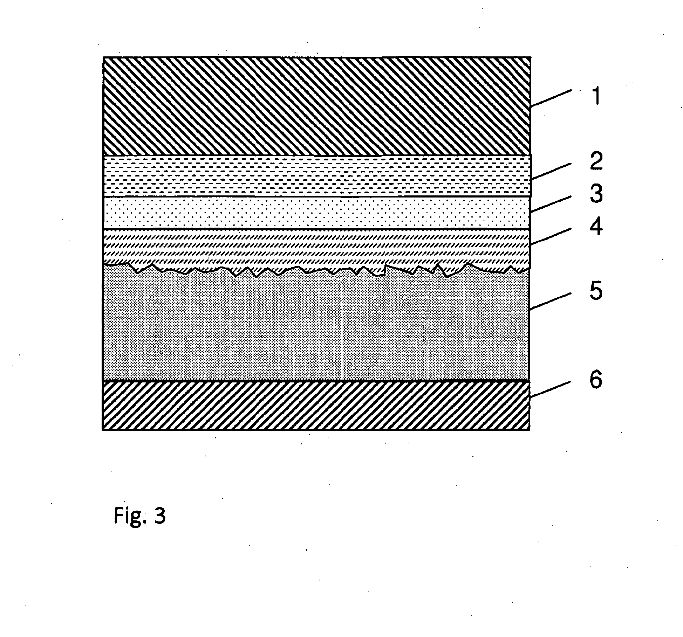

Wird diese TCO-Schicht 4 als Frontkontakt genutzt, kann darauf folgend der für eine Dünnschichtsolarzelle bekannte fotoaktiver Schichtstapel 5, das grundsätzlich einen Absorber aufweist und dessen detaillierter Aufbau jedoch verschieden ausgeführt sein kann und auf den abschließend ein Rückseitenkontakt 6 folgt, abgeschieden werden (siehe Fig. 3).

Die Abscheidung zumindest der Barriere- 2, der Keim- 3 und der TCO-Schichten 4 erfolgt durch Sputtern in einer Durchlaufanlage. Für die Herstellung des darauf folgenden fotoaktiver Schichtstapel 5, welcher den Absorber und darauf den Rückseitenkontakt 6 aufweist, wird auf die bekannten Verfahren verwiesen, die der jeweiligen Schichtenfolge angepasst sind.

Die so auf dem Schichtstapel aus Barriereschicht 2, Keimschicht 3 und TCO-Schicht 4 auf dem Floatglassubstrat 1 hergestellte Dünnschichtsolarzelle zeigt im Fall der Verwendung des Schichtstapels der Figs. 2a und 2b einen signifikant höheren Wirkungsgrad als die auf dem Schichtstapel aus Barriereschicht 2, Keimschicht 3 und TCO-Schicht 4 der Figs. 1a und 1b auf dem Floatglassubstrat 1 hergestellte Dünnschichtsolarzelle.

## Patentansprüche

1. Verfahren zur Beschichtung eines Substrats (1) mit einer transparenten leitfähigen Oxidschicht, nachfolgend als TCO-Schicht (4) bezeichnet, wobei folgende Schichten unmittelbar nacheinander auf dem Substrat (1) mittels Sputtern abgeschieden werden:
- Abscheidung einer Barriereschicht (2) zur Behinderung einer Materialeinwirkung auf eine darüber abgeschiedene Schicht, die durch Diffusion von Material aus dem Substrat (1) in Richtung der darüber liegenden Schichten erfolgen kann,
- Abscheidung einer Keimschicht (3) aus einem SiOxNy oder SiOx oder SixNy mit 0<x≤3 und 0<y≤4, welches geeignet ist, zur Einstellung eines definierten Schichtwachstums einer nachfolgenden TCO-Schicht (4) und
- Abscheidung der TCO-Schicht (4) mit einem Säulenwachstum.

2. Verfahren nach Anspruch 1, wobei die Barriereschicht (2) aus einem SiOₓN_{y} oder SiOₓ oder SiₓN_{y} mit 0<x≤3 und 0<y≤4 besteht und wobei zur Einstellung einer Barrierewirkung gegen die Diffusion von Material aus dem Substrat in Richtung der darüber liegenden Schichten geeignete Prozessparameter zur Herstellung dieser Barriereschicht (2) gewählt und eingestellt werden.

3. Verfahren nach einem der vorstehenden Ansprüche, wobei die Eigenschaften der nachfolgenden TCO-Schicht (4) durch einen Wechsel von Wachstumsphasen mit Ruhephasen und/oder Rücksputterphasen während der Abscheidung der Keimschicht (3) eingestellt werden.

4. Verfahren nach einem der vorstehenden Ansprüche, wobei nach der Abscheidung der TCO-Schicht (4) deren Oberfläche durch Ätzen strukturiert und/oder aufgerauht wird.

5. Dünnschichtsolarzelle mit einem transparenten Substrat (1) und einem darauf angeordneten Schichtsystem, welches folgende Schichten vom Substrat (1) aufwärts unmittelbar aufeinanderfolgend umfasst:
- Barriereschicht (2) zur Behinderung einer Materialeinwirkung auf eine darüber liegende Schicht der Dünnschichtsolarzelle, insbesondere deren fotoaktive Schichten (5), die durch Diffusion von Material aus dem Substrat (1) in Richtung der darüber liegenden Schichten erfolgen kann,
- Keimschicht (3) aus einem SiOxNy oder SixNy mit 0<x≤3 und 0<y≤4, welches geeignet ist, ein definiertes Schichtwachstum für eine auf der Keimschicht (3) abzuscheidenden TCO-Schicht (4) zu erzeugen,
- TCO-Schicht (4) als eine erste Kontaktschicht,
- fotoaktiver Schichtstapel (5) und
- Gegenkontakt (6) als eine zweite Kontaktschicht,
- wobei die TCO-Schicht (4) eine säulenartige Kristallitstruktur aufweist.

6. Dünnschichtsolarzelle nach Anspruch 5, wobei die TCO-Schicht (4) eine strukturierte und/oder aufgerauhte Oberfläche aufweist.

7. Dünnschichtsolarzelle nach einem der Ansprüche 5 oder 6, wobei die Barriereschicht (2) aus einem SiOₓN_{y} oder SiOₓ oder SiₓN_{y} mit 0<x≤3 und 0<y≤4 mit einer Barrierewirkung gegen die Diffusion von Material aus dem Substrat (1) in Richtung der darüber liegenden Schichten besteht.

8. Dünnschichtsolarzelle nach einem der Ansprüche 5 bis 7, wobei die Keimschicht (3) einen Gradienten und/oder eine sprunghafte Änderung ihrer Schichteigenschaften aufweist.

## Claims

1. Method for coating a substrate (1) having a transparent conductive oxide layer, referred to hereinbelow as TCO layer (4), wherein the following layers are deposited in direct succession on the substrate (1) by means of sputtering:
- deposition of a barrier layer (2) to hinder the effect material has on a layer deposited thereabove, which can be effected by diffusion of material from the substrate (1) in the direction of the layers lying thereabove,
- deposition of a seed layer (3) consisting of an SiOₓN_{y} or SiOₓ or SiₓN_{y} where 0 < x ≤ 3 and 0 < y ≤ 4, which is suitable for setting a defined layer growth of a subsequent TCO layer (4), and
- deposition of the TCO layer (4) with a columnar growth.

2. Method according to Claim 1, wherein the barrier layer (2) consists of an SiOₓN_{y} or SiOₓ or SiₓN_{y} where 0 < x ≤ 3 and 0 < y ≤ 4, and wherein, to set a barrier action against the diffusion of material from the substrate in the direction of the layers lying thereabove, suitable process parameters are chosen and set for producing said barrier layer (2).

3. Method according to either of the preceding claims, wherein the properties of the following TCO layer (4) are set by a change of growth phases to resting phases and/or resputter phases during the deposition of the seed layer (3).

4. Method according to one of the preceding claims, wherein the surface of the TCO layer (4) is structured and/or roughened by etching after it has been deposited.

5. Thin film solar cell having a transparent substrate (1) and a layer system arranged thereon comprising the following layers in direct succession from the substrate (1) upwards:
- a barrier layer (2) to hinder the effect material has on a layer of the thin film solar cell lying thereabove, in particular the photoactive layers (5) thereof, which can be effected by diffusion of material from the substrate (1) in the direction of the layers lying thereabove,
- a seed layer (3) consisting of an SiOₓN_{y} or SiₓN_{y} where 0 < x ≤ 3 and 0 < y ≤ 4, which is suitable for generating a defined layer growth for a TCO layer (4) to be deposited on the seed layer (3),
- a TCO layer (4) as a first contact layer,
- a photoactive layer stack (5), and
- a counter-contact (6) as a second contact layer,
- wherein the TCO layer (4) has a column-like crystallite structure.

6. Thin film solar cell according to Claim 5, wherein the TCO layer (4) has a structured and/or roughened surface.

7. Thin film solar cell according to either of Claims 5 and 6, wherein the barrier layer (2) consists of an SiOₓN_{y} or SiOₓ or SiₓN_{y} where 0 < x ≤ 3 and 0 < y ≤ 4 with a barrier action against the diffusion of material from the substrate (1) in the direction of the layers lying thereabove.

8. Thin film solar cell according to one of Claims 5 to 7, wherein the seed layer (3) has a gradient and/or a sudden change in the layer properties thereof.

## Revendications

1. Procédé de revêtement d'un substrat (1) par une couche d'oxyde transparent et conducteur, appelée couche TCO (4) dans ce qui suit, dans lequel les couches suivantes sont déposées en succession immédiate sur le substrat (1) au moyen d'une pulvérisation:
- dépôt d'une couche de barrière (2) qui empêche qu'un matériau puisse agir sur une couche déposée par dessus par diffusion du matériau depuis le substrat (1) en direction des couches située par dessus,
- dépôt d'une couche de germination (3) en SiOxNy, SiOx ou SixNy avec 0 < x ≤ 3 et 0 < y ≤ 4, qui convient pour établir une croissance définie pour une couche TCO (4) qui suit et
- dépôt de la couche TCO (4) avec une croissance en colonnes.

2. Procédé selon la revendication 1, dans lequel la couche de barrière (2) est constituée de SiOxNy, SiOx ou SixNy avec 0 < x ≤ 3 et 0 < y ≤ 4 et dans lequel des paramètres appropriés de traitement sont sélectionnés et établis pour la formation de cette couche de barrière (2) en vue de l'établissement d'un effet de barrière vis-à-vis de la diffusion du matériau du substrat en direction des couches situées par dessus.

3. Procédé selon l'une des revendications précédentes, dans lequel les propriétés de la couche TCO (4) qui suit sont établies par alternance de phase de croissance et de phase de repos et/ou de phase de repulvérisation pendant le dépôt de la couche de germination (3).

4. Procédé selon l'une des revendications précédentes, dans lequel la surface de la couche TCO (4) est structurée et/ou rendue rugueuse par gravure après son dépôt.

5. Cellule solaire en couche mince dotée d'un substrat transparent (1) sur lequel est disposé un système de couches qui comporte les couches suivantes en succession immédiate à partir du substrat (1) :
- une couche de barrière (2) qui empêche que le matériau du substrat (1) puisse agir sur la couche de la cellule solaire en couche mince, en particulier sur ses couches photoactives (5), qui y est placée par diffusion du matériau en direction des couches situées par dessus,
- une couche de germination (3) en SiOxNy ou SixNy avec 0 < x ≤ 3 et 0 < y ≤ 4 qui permet de former une croissance définie pour une couche TCO (4) à déposer sur la couche de germination (3),
- une couche TCO (4) comme première couche de contact,
- l'empilement photoactif (5) de couches et
- un contre-contact (6) configuré sous la forme d'une deuxième couche de contact,
- dans laquelle la couche TCO (4) présente une structure en critallites en forme de colonne.

6. Cellule solaire en couche mince selon la revendication 5, dans laquelle la couche TCO (4) présente une surface structurée et/ou rendue rugueuse.

7. Cellule solaire en couche mince selon l'une des revendications 5 ou 6, dans laquelle la couche de barrière (2) est constituée de SiOxNy, SiOx ou SixNy avec 0 < x ≤ 3 et 0 < y ≤ 4 avec un effet de barrière contre la diffusion du matériau de substrat (1) en direction des couches situées par dessus.

8. Cellule solaire en couche mince selon l'une des revendications 5 à 7, dans laquelle la couche de germination (3) présente un gradient et/ou une modification brusque de ses propriétés.
